(19) **Europäisches Patentamt / European Patent Office / Office européen des brevets**

(11) **EP 3 658 944 B1**

(12) **FASCICULE DE BREVET EUROPEEN**

(45) Date de publication et mention de la délivrance du brevet:
**19.05.2021 Bulletin 2021/20**

(21) Numéro de dépôt: **18755527.1**

(22) Date de dépôt: **26.07.2018**

(51) Int Cl.:
**G01R 33/00** *(2006.01)*

(86) Numéro de dépôt international:
**PCT/FR2018/051929**

(87) Numéro de publication internationale:
**WO 2019/020955 (31.01.2019 Gazette 2019/05)**

(54) **PROCÉDÉ DE CALIBRATION D'UN MAGNÉTOMÈTRE**

VERFAHREN ZUR KALIBRIERUNG EINES MAGNETOMETERS

METHOD FOR CALIBRATING A MAGNETOMETER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.07.2017 FR 1757084**

(43) Date de publication de la demande:
**03.06.2020 Bulletin 2020/23**

(73) Titulaire: **SYSNAV**
**27200 Vernon (FR)**

(72) Inventeurs:
• **VISSIERE, David**
**75009 Paris (FR)**
• **CHESNEAU, Charles-Ivan**
**75008 Paris (FR)**
• **HILLION, Mathieu**
**27200 Vernon (FR)**

• **MEIER, Hendrik**
**27200 Vernon (FR)**

(74) Mandataire: **Regimbeau**
**20, rue de Chazelles**
**75847 Paris Cedex 17 (FR)**

(56) Documents cités:
EP-A1- 2 685 273      EP-A2- 1 803 413
US-A1- 2010 307 016   US-A1- 2011 084 692
US-A1- 2016 041 234   US-A1- 2017 115 364
US-B1- 6 242 907

• ZHANG ZHI-QIANG: "Two-Step Calibration Methods for Miniature Inertial and Magnetic Sensor Units", IEEE TRANSACTIONS ON INDUSTRIAL ELECTRONICS, IEEE SERVICE CENTER, PISCATAWAY, NJ, USA, vol. 62, no. 6, 1 juin 2015 (2015-06-01), pages 3714-3723, XP011580617, ISSN: 0278-0046, DOI: 10.1109/TIE.2014.2375258 [extrait le 2015-05-08]

EP 3 658 944 B1

**Description**

DOMAINE TECHNIQUE GENERAL

La présente invention concerne le domaine de la calibration de capteurs.

Plus précisément, elle concerne un procédé de calibration d'au moins un magnétomètre.

Un magnétomètre peut être utilisé dans pour diverses applications, comme par exemple la navigation sans GPS, ou la détection des métaux.

ETAT DE L'ART

Le champ magnétique est un champ vectoriel en l'espèce tridimensionnel, c'est-à-dire associant un vecteur champ magnétique noté $\vec{B}$ et de dimension trois à chaque emplacement de l'espace. Le champ magnétique en un point se caractérise ainsi par sa norme et sa direction.

Un magnétomètre permet de mesurer le champ magnétique en un point. Un magnétomètre peut être un magnétomètre mono-axial, capable de mesurer une composante du champ magnétique dans une position, i.e. la projection du vecteur champ magnétique $\vec{B}$ au niveau dudit magnétomètre selon son axe. Un magnétomètre peut également être un magnétomètre triaxe, capable de mesurer le champ magnétique selon ses trois axes, qui peut être constitué de trois magnétomètres mono-axe rigidement liés entre eux et orientés selon des axes différents, généralement sensiblement orthogonaux.

Toutefois, la mesure du champ magnétique par un magnétomètre n'est pas parfaite, de sorte que la mesure du champ magnétique dévie du champ magnétique réel. Par exemple, des effets de fers durs peuvent être crées par rémanence des certains composants à de forts champs magnétiques et entraîner des biais de mesure. Des facteurs d'échelle peuvent également distordre la mesure. Par ailleurs, des effets dus à la configuration physique du magnétomètre et au montage du magnétomètre peuvent également affecter la mesure.

On peut ainsi par exemple écrire la mesure d'un magnétomètre tri-axe sous la forme linéaire suivante :

$$\vec{B}_m = D\vec{B} + \vec{b}$$

où $\vec{B}_m$ est la mesure du champ magnétique par le magnétomètre, $\vec{B}$ est le champ magnétique réel, D est un facteur d'échelle (représenté par une matrice diagonale ou pleine), et $\vec{b}$ est un biais de mesure. Le facteur d'échelle et le biais de mesure sont donc des paramètres de mesure qui viennent polluer la mesure du champ magnétique par rapport au champ magnétique réel. Il convient donc d'estimer ces paramètres, ou au moins un, afin de pouvoir corriger la mesure du champ magnétique.

La calibration d'un magnétomètre revient à déterminer au moins un de ces paramètres et à en déduire des corrections à apporter aux sorties du magnétomètre afin que la mesure corrigée reflète plus fidèlement le champ magnétique réel.

De plus, la calibration permet de déterminer la position du magnétomètre dans un repère lié au support sur lequel ledit magnétomètre est (l'orientation du magnétomètre et son emplacement dans l'espace).

Une calibration précise du magnétomètre est notamment requise pour les applications qui requièrent une grande précision. En particulier, une centrale magnéto-inertielle peut comprendre, outre des accéléromètres, un réseau de plusieurs magnétomètres disposés à des emplacements différents qui permettent l'estimation simultanée du champ et du gradient magnétique. La précision de ces mesures est essentielle à la bonne performance de reconstruction du mouvement de la centrale magnéto-inertielle.

Une méthode de calibration existante, appelée « *méthode en champ libre »,* consiste à placer les magnétomètres à calibrer dans un endroit aussi éloigné que possible de toute source de perturbations magnétiques. Cette méthode est très contraignante car les endroits éloignés des sources de perturbations magnétiques sont très reculés. De plus, les conditions d'isolement de toute source de perturbations magnétiques sont de plus en plus compromises par les diverses constructions humaines.

Une autre méthode de calibration connue utilise des bobines de type Helmholtz, Braunbek, ou autre. Cette solution nécessite toutefois de procéder au préalable à un étalonnage des bobines avec un magnétomètre étalon. Une grande part de la précision du calibrage des magnétomètres dépend de cette étape d'étalonnage des bobines qui d'une part est complexe et d'autre part nécessite une grande précision. De plus, afin d'obtenir la précision désirée, il peut alors être nécessaire d'étalonner le magnétomètre étalon, complexifiant et rallongeant d'autant plus la méthode de calibration US 2017/115364 A1 divulgue la cartographie des champs magnétiques. Zhang Zhi-Qiang, "Two-Step Calibration Methods for Miniature Inertial and Magnetic Sensor Units", IEEE Trans. on Industrial Electronics, IEEE Service Center, Piscataway, NJ, USA, vol. 62, no. 6, 1 juin 2015, pages 3714-3723 montre des méthodes d'étalonnage en deux étapes pour les capteurs inertiels et les capteurs magnétiques miniatures.

En outre, certaines méthodes de calibration connues utilisant des bobines de Helmholtz nécessitent de placer les magnétomètres à calibrer dans une zone sur laquelle un champ magnétique homogène est créé par les bobines de Helmholtz. Une telle méthode est par exemple décrite dans le document US2017/0067981. Une telle méthode possède l'inconvénient qu'il devient nécessaire d'utiliser des bobines avec un rayon très important pour pouvoir calibrer certains objets, ce qui pose des problèmes d'encombrement. En effet, les magnétomètres à calibrer doivent être situés dans la zone sur laquelle le champ magnétique créé par les bobines de Helmholtz est homogène, et la taille de cette zone sur laquelle le champ magnétique est homogène dépend de la taille des bobines de Helmholtz. Or, les magnétomètres sont calibrés en étant montés sur un support, comme une carte électronique par exemple, qui est généralement disposé dans un objet, comme un boîtier par exemple, car l'objet et le support peuvent interférer sur la mesure du champ magnétique par les magnétomètres. La zone sur laquelle le champ magnétique est homogène doit être suffisamment grande afin de pouvoir contenir l'objet.

Il serait donc souhaitable de disposer d'une nouvelle méthode de calibration d'un magnétomètre qui est à la fois précise et simple à mettre en œuvre, et qui ne nécessite pas d'être effectuée dans un endroit éloigné de toute source de perturbations magnétiques.

PRESENTATION DE L'INVENTION

La présente invention se rapporte ainsi selon un premier aspect à un procédé de calibration d'un magnétomètre, le procédé étant caractérisé en ce qu'il comprend les étapes suivantes :

E1 : placer au moins un magnétomètre à l'intérieur d'un générateur d'un champ magnétique, ledit générateur comprenant une pluralité de bobinages ;

E2 : générer un champ magnétique dans le générateur en appliquant un courant électrique à chaque bobinage ;

E3 : mesurer le champ magnétique généré dans le générateur avec le au moins un magnétomètre, et mesurer les courants électriques appliqués aux bobinages du générateur ;

E4 : répéter l'étape E3 en modifiant à chaque fois une position dudit au moins un magnétomètre à l'intérieur du générateur et/ou les courants électriques dans les bobinages du générateur, de sorte à obtenir des mesures du champ magnétique et des courants électriques appliqués aux bobinages pour une pluralité de positions dudit au moins un magnétomètre et/ou de courants électriques dans les bobinages ;

E5 : générer un modèle de transfert paramétrique à partir d'un modèle de mesure paramétrique dudit au moins un magnétomètre et d'un modèle paramétrique du champ magnétique, le modèle de mesure paramétrique dudit au moins un magnétomètre comprenant des paramètres de calibration dudit au moins un magnétomètre ;

E6 : calculer les paramètres de calibration du au moins un magnétomètre avec un algorithme d'optimisation à partir et du modèle de transfert paramétrique généré à l'étape E5 et des mesures du champ magnétique et des courants électriques réalisées dans les étapes E3 et E4.

Selon d'autres caractéristiques avantageuses et non limitatives :

- le procédé comprend l'étape suivante :
  E40 : calculer un modèle de transfert mesuré entre la mesure du champ magnétique par le au moins un magnétomètre et les courants électriques appliqués aux bobinages pour les différentes positions dudit au moins un magnétomètre et/ou les différents courants électriques dans les bobinages, à partir d'une part des mesures dudit champ magnétique et d'autre part des mesures desdits courants électrique appliqués aux bobinages,
  le calcul des paramètres de calibration étant réalisé avec un algorithme d'optimisation à partir du modèle de transfert paramétrique et des modèles de transfert mesurés ;
- le procédé comprend en outre une étape de contrôle la température dudit au moins un magnétomètre à calibrer ;
- le au moins un magnétomètre possède une réponse linéaire, le modèle de transfert mesuré étant un matrice de transfert mesurée qui est calculée par régression linéaire, le modèle de transfert paramétrique étant une matrice de transfert paramétrique ;
- le au moins un magnétomètre possède une réponse non-linéaire, le modèle de transfert mesuré étant calculé avec un modèle polynomial ou un modèle en séries de Fourier ;
- le générateur est un dispositif à bobines de Helmholtz triaxes comprenant six bobinages ;
- le procédé comprend une étape d'identification d'un biais dudit au moins un magnétomètre, l'étape d'identification étant réalisée en plaçant ledit au moins un magnétomètre dans un dispositif isolant ledit au moins un magnétomètre de tout champ magnétique ;
- le procédé est appliqué sur une pluralité de magnétomètres, les paramètres de calibration des magnétomètres comprenant un emplacement des magnétomètres défini par rapport à un des magnétomètres servant de référence ;

- le au moins un magnétomètre est maintenu fixe durant l'étape E2 de génération du champ magnétique à l'intérieur du générateur et durant l'étape E3 de mesure du champ magnétique et du courant électrique appliqué à chacun des bobinages ;
- les paramètres de calibration du au moins un magnétomètre comprennent : une position dudit au moins un magnétomètre sur un support sur lequel ledit au moins un magnétomètre est monté, un facteur directionnel de mesure dudit au moins un magnétomètre, et/ou un biais dudit au moins un magnétomètre ;
- le modèle paramétrique du champ magnétique est un modèle de champ d'ordre 1, un modèle de champ d'ordre 2, ou un modèle à éléments finis.

Selon un deuxième aspect, l'invention concerne un équipement de calibration d'au moins un magnétomètre comprenant au moins un magnétomètre, un générateur d'un champ magnétique qui comprend une pluralité de bobinages, caractérisé en ce qu'il comprend également un capteur de courant configuré pour mesurer le courant dans chacun des bobinages, et des moyens de traitement qui sont configurés pour :

- générer un modèle de transfert paramétrique à partir d'un modèle de mesure paramétrique dudit au moins un magnétomètre et d'un modèle paramétrique du champ magnétique, le modèle de mesure paramétrique dudit au moins un magnétomètre comprenant des paramètres de calibration dudit au moins un magnétomètre ;
- calculer les paramètres de calibration du au moins un magnétomètre avec un algorithme d'optimisation à partir du modèle de transfert paramétrique et de mesures du champ magnétique par ledit au moins un magnétomètre et de mesures des courants dans les bobinages.

Selon une autre caractéristique avantageuse et non limitative, le générateur est un dispositif à bobines de Helmholtz triaxes comprenant six bobinages.

Selon un troisième aspect, l'invention concerne un produit programme d'ordinateur comprenant des instructions de code pour l'exécution d'un procédé de calibration d'au moins un magnétomètre selon le premier aspect de l'invention.

Selon un quatrième aspect, l'invention concerne un moyen de stockage lisible par un équipement informatique sur lequel un produit programme d'ordinateur comprend des instructions de code pour l'exécution d'un procédé de calibration d'au moins un magnétomètre selon le premier aspect de l'invention.

Un but de l'invention est de simplifier la calibration d'un magnétomètre, notamment par détermination du facteur directionnel de mesure du magnétomètre, de son biais, et/ou de son emplacement sur son support.

Un autre but de l'invention est de calibrer de manière simultanée un magnétomètre et un modèle paramétrique du champ magnétique.

Un autre but de l'invention est de pouvoir étalonner ou optimiser les systèmes de calibration actuels.

## PRESENTATION DES FIGURES

D'autres caractéristiques et avantages de la présente invention apparaîtront à la lecture de la description qui va suivre d'un mode de réalisation préférentiel. Cette description sera donnée en référence aux dessins annexés dans lesquels :

- la figure 1 est un schéma représentant une variante possible d'un équipement pour la mise en œuvre du procédé selon l'invention ;
- La figure 2 représente une mise en œuvre possible du procédé selon l'invention ;
- La figure 3 représente une variante possible du procédé selon l'invention.

## DESCRIPTION DETAILLEE

*Principe*

Le présent procédé propose d'utiliser un générateur de champ magnétique, comme par exemple un dispositif à bobines de Helmholtz de Braunbek ou de Maxwell.

De plus, le procédé propose, au lieu de calibrer le générateur puis de calibrer les magnétomètres, de calibrer simultanément les magnétomètres et le générateur.

Un aspect de l'invention repose sur le fait qu'il est possible de :

- déterminer des paramètres de calibration des magnétomètres, notamment un emplacement et une orientation des magnétomètres sur le support sur lequel lesdits magnétomètres sont montés, un facteur directionnel de mesure, et un biais ; et

- déterminer des paramètres du modèle de champ magnétique généré par le générateur

par utilisation d'un algorithme d'optimisation entre des mesures du champ magnétique généré par le générateur effectuées par les magnétomètres à calibrer et un modèle de mesure paramétrique, ledit modèle de mesure paramétrique étant basé sur modèle paramétrique du champ magnétique et sur un modèle paramétrique de mesure du magnétomètre qui comprend les paramètres de calibration dudit magnétomètre.

Il n'y a donc pas besoin de connaître le champ magnétique généré par le générateur, comme cela est le cas dans les méthodes de calibration connues dans lesquelles le générateur est calibré afin de connaitre précisément les propriétés du champ magnétique généré par ledit générateur. Dans cet aspect de l'invention, il suffit d'utiliser un modèle paramétrique du champ magnétique qui est choisi par l'utilisateur sans prendre en compte les paramètres du champ magnétique que génère véritablement le générateur.

Les mesures du champ magnétique du générateur sont réalisées en faisant varier la position des magnétomètres à l'intérieur du générateur.

Outre les paramètres de calibration du magnétomètre, cette solution peut en outre permettre de déterminer les paramètres du modèle paramétrique du champ magnétique.

On entend ici par position la combinaison d'un emplacement et d'une orientation, ce qui permet de décrire complètement la configuration spatiale d'un objet. Dans une écriture vectorielle d'un espace à trois dimensions, l'emplacement est défini par un vecteur à trois composantes (les coordonnées spatiales dans un repère), et l'orientation est également définie par un vecteur à trois composantes (les angles de rotation par rapport au repère).

*Equipement*

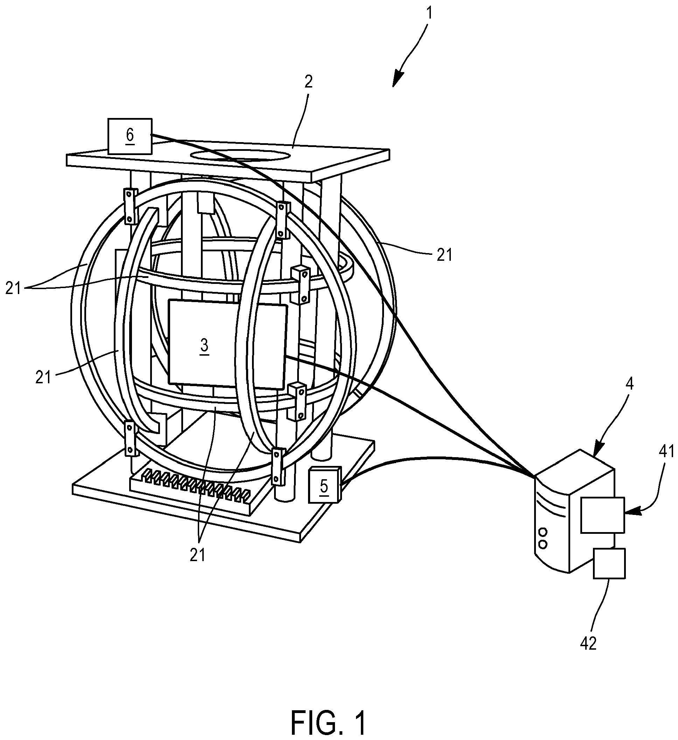

En référence à la **figure 1,** un équipement 1 de calibration d'au moins un magnétomètre 3 comprend :

- un générateur 2 d'un champ magnétique comprenant des bobinages 21. Le générateur 2 génère un champ magnétique lorsque des courants électriques circulent dans les bobinages 21. Dans la variante représentée sur la figure 1 le générateur 1 est un dispositif à bobines de Helmholtz triaxes comprenant six bobinages 21. Le au moins un magnétomètre 3 à calibrer, de manière générale une pluralité de magnétomètres 3 disposés sur un support (comme par exemple une carte électronique), est disposé à l'intérieur du générateur 2. Dans la variante illustrée sur la **figure 1,** le ou les magnétomètres 3 à calibrer sont disposé(s) entre les bobinages 21 du générateur 2 à bobines de Helmholtz.
- des moyens de traitement 4, par exemple un ordinateur, qui comprennent un processeur 41 et une mémoire 42 et qui sont configurés pour mettre en œuvre un procédé selon l'invention. Les moyens de traitement 4 sont connectés au générateur 2 et audit au moins un magnétomètre 3. Les moyens de traitement 4 peuvent ainsi contrôler les courants électriques dans les bobinages 21 du générateur 2, et obtenir les données mesurées par le ou les magnétomètre(s) 3.
- un capteur de courant 5 configuré pour mesurer le courant électrique dans chacun des bobinages 21 du générateur. Le capteur de courant 5 est connecté aux moyens de traitement 4.

L'équipement 1 peut également comprendre des moyens de contrôle 6 de la température du au moins un magnétomètre 3. En effet, les magnétomètres peuvent être sensibles à la température. Il est ainsi avantageux de maintenir le ou les magnétomètres 3 à calibrer à la température désirée avec les moyens de contrôle 6 de la température dudit au moins un magnétomètre 3. Typiquement, les moyens de contrôle 6 de la température peuvent imposer que la température à l'intérieur du générateur 2 reste constante, par exemple avec des moyens de réchauffe et/ou des moyens de refroidissement, comme par exemple une résistance chauffante ou une pompe à chaleur.

*Procédé*

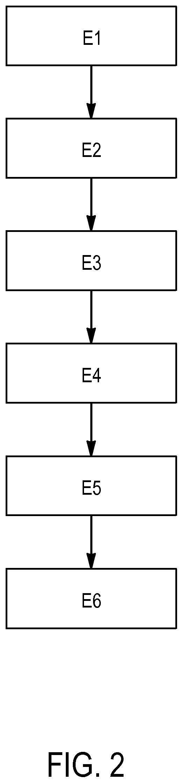

Comme illustré sur la **figure 2,** le procédé de calibration du au moins un magnétomètre 3 comprend les étapes suivantes :

E1 : placer au moins un magnétomètre 3 à calibrer à l'intérieur du générateur 2 de champ magnétique ;
E2 : générer un champ magnétique dans le générateur 2 en appliquant des courants électriques aux différents bobinages 21 dudit générateur 2 ;
E3 : mesurer le champ magnétique généré dans le générateur 2 avec le au moins un magnétomètre 3, et mesurer les courants électriques appliqués aux bobinages 21 du générateur 2 avec le capteur de courant 6 ;
E4 : répéter l'étape E3 (mesurer ledit champ magnétique ainsi que les courants électriques dans les bobines) en modifiant à chaque fois une position dudit au moins un magnétomètre 3 à l'intérieur du générateur 2, et/ou les courants électriques dans les bobinages 21 du générateur 2. Une mesure du champ magnétique et des courants appliqués aux bobinages 21 étant obtenue pour chaque positionnement du magnétomètre 3 et/ou variation des courants électriques dans les bobinages 21. Typiquement, une série de 36 mesures peut être effectuée avec deux magnétomètres 3 monoaxe, ou 18 avec un magnétomètre 3 triaxes, en changeant de position les magnétomètres 3 de position et/ou les courants électriques dans les bobinages 21 entre chaque mesure. La variation des courants électriques dans les bobinages 21 peut par exemple être fait par une variation de l'intensité et/ou une variation de la tension. Le fait de faire varier la position du au moins un magnétomètre 3 et/ou des courants dans les bobinages 21 permet d'obtenir des mesures avec dans des conditions différentes afin de pouvoir être utilisées pour un algorithme d'optimisation.

E5 : générer un modèle de transfert paramétrique à partir d'un modèle de mesure paramétrique dudit au moins un magnétomètre 3 et d'un modèle paramétrique du champ magnétique, le modèle de mesure paramétrique dudit au moins un magnétomètre comprenant les paramètres de calibration dudit au moins un magnétomètre 3.

E6 : calculer les paramètres de calibration du au moins un magnétomètre 3 avec un algorithme d'optimisation à partir du modèle de transfert paramétrique généré à l'étape E5, et des mesures du champ magnétique et des courants pour les différents positionnements dudit au moins un magnétomètre 3 obtenues lors des étapes E3 et E4. L'algorithme d'optimisation peut être une descente de gradient, un algorithme de Levenberg-Marquardt, ou un algorithme de Metropolis-Hastings.

L'algorithme d'optimisation est initialisé en générant le modèle de transfert paramétrique. Une fonction coût est ensuite évaluée à partir des mesures des courants dans les bobinages 21 et des mesures du champ magnétique par le au moins un magnétomètre 3. Une valeur des paramètres de calibration du magnétomètre, ainsi que des autres paramètres du modèle paramétrique, est déterminée afin de réduire la fonction coût.

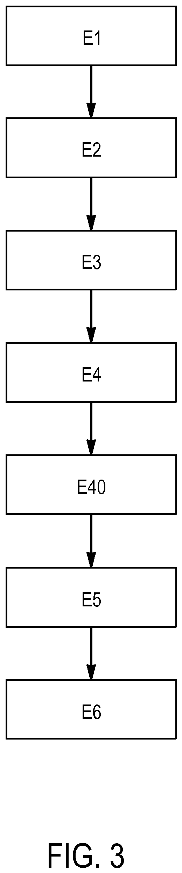

Selon une variante illustrée sur la **figure 3,** le procédé peut comprendre une étape E40 pour calculer un modèle de transfert mesuré entre le champ magnétique généré et les courants électriques appliqués aux bobinages 21 pour les différentes positions dudit au moins un magnétomètre 3 et/ou les différents courants électriques dans les bobinages, à partir d'une part des mesures dudit champ magnétique et d'autre part des mesures desdits courants électrique appliqués aux bobinages 21.

Le calcul d'une matrice de transfert à partir des mesures peut par exemple être réalisé par régression linéaire. D'autres méthodes peuvent également être utilisés pour calculer le modèle de transfert et ainsi décrire le lien entre les mesures du champ magnétique et les courants dans les bobinages 21, comme par exemple avec un modèle polynomial, ou un modèle en séries de Fourier, qui sont des méthodes adaptées si la réponse des magnétomètres 3 n'est pas linéaire.

Dans cette variante, le calcul des paramètres de calibration de l'étape E6 est réalisé avec un algorithme d'optimisation à partir du modèle de transfert paramétrique et des modèles de transfert mesurés. Les étapes d'évaluation d'une fonction coût et de détermination des paramètres de calibration réduisant cette fonction coût sont répétées avec les modèles de transfert mesurés des différentes positions du magnétomètre dans le générateur, jusqu'à trouver un minium local ou global.

Ce procédé permet donc également de déterminer les paramètres d'un modèle de champ magnétique, lesdits paramètres étant compris dans le modèle paramétrique du champ magnétique.

Il va maintenant être décrit comment il est possible de calculer les paramètres de calibration du ou des magnétomètre(s) 3, et les paramètres de calibration du champ magnétique généré par le générateur 2 avec un tel procédé.

Le champ magnétique généré par le générateur 2 est une fonction affine par rapport aux courants électriques circulant dans les bobinages 21 dudit générateur.

Ainsi, si l'on note $B(X)$ le champ magnétique en fonction de la position $X$ à l'intérieur du générateur 2, il est possible d'écrire :

$$B(X) = T(X)\vec{I}$$

où $\vec{I}$ est un vecteur comprenant la liste de tous les courants électriques indépendants dans chaque bobinages 21, et où $T(X)$ désigne une matrice de transfert (un modèle de transfert dans le cas d'un magnétomètre linéaire).

Les courants électriques sont mesurés par le capteur de courant 6, qui transmet les données mesurées aux moyens de traitement 4.

Le champ magnétique en chaque point s'obtient donc par combinaison linéaire des courants électriques dans chaque bobinage 21 par l'intermédiaire de la matrice de transfert $T(X)$.

Un magnétomètre 3 fournit typiquement une mesure du champ magnétique dans une direction donnée. Lorsqu'un magnétomètre 3 est positionné immobile à proximité des bobinages 21, le champ magnétique mesuré par ledit magnétomètre 3 peut donc être exprimé comme fonction des courants $\vec{I}$, et de paramètres de calibration comprenant par exemple l'emplacement X dudit magnétomètre 3 sur le support sur lequel ledit magnétomètre 3 est placé, du facteur directionnel de mesure du magnétomètre (qui comprend le paramètre d'échelle dudit magnétomètre 3), et du biais dudit magnétomètre 3.

Dans des bobines de Helmholtz (et dans d'autres configuration de générateur à bobinages comme ceux du type bobines de Maxwell ou Braunbek) on peut montrer théoriquement que deux ensembles de mesures physiquement équivalentes ne peuvent se distinguer que par le choix :

- d'une origine du repère des bobinages 21 ;
- d'une définition des axes du repère des bobinages 21 ;
- d'un facteur d'échelle sur le champ magnétique émis par les bobinages 21 ;
- d'un facteur d'échelle sur les longueurs.

Ces choix peuvent s'écrire sous la forme de contraintes sur les paramètres identifiés. Par exemple, le facteur d'échelle sur le champ magnétique émis par les bobinages 21 peut être défini en imposant le facteur d'échelle d'un magnétomètre, ou en imposant une valeur de champ à l'origine du générateur 2.

Pour une pluralité de magnétomètres 3 monoaxiaux, à réponse linéaire (le procédé de l'invention s'applique cependant à d'autres modèles de magnétomètres, comme par exemple des magnétomètres à modèles non-linéaire), qui sont fixés de manière rigide sur leur support, comme par exemple une carte électronique (appelée carte capteur) qui est montée sur un objet, lesdits magnétomètres 3 étant considérés comme ponctuels et supposés sans biais, il est possible de définir le modèle de mesure paramétrique (ou modèle de calibration) suivant pour chaque magnétomètre 3 :

$$Y^i(X) = \sum_j d_j^i C^j(X) \qquad (1)$$

Où $Y^i(X)$ représente la mesure scalaire du magnétomètre $i$ lorsqu'il est placé au point $X$, et les $C^i(X)$ représentent les trois composantes du champ magnétique au point $X$. Et où $d_j^i$ représente un facteur directionnel de mesure associé au magnétomètre i.

Le facteur directionnel de mesure $d_j^i$ est un paramètre de calibration du magnétomètre qui comprend plusieurs informations sur le magnétomètre. En effet, le facteur directionnel de mesure indique d'une part la manière dont le magnétomètre mesure les différentes composantes du champ magnétique, et d'autre part le facteur d'échelle du magnétomètre. Par exemple, si : $d^i = (1 + \varepsilon_X ; \varepsilon_Y; \varepsilon_Z)$, avec $\varepsilon_X, \varepsilon_Y, \varepsilon_Z \ll 1$ alors le magnétomètre associé est un capteur mesurant globalement la direction X du champ magnétique et souffre d'un problème de facteur d'échelle axial par rapport à X ($\varepsilon_X$) et de problème d'alignement par rapport aux axes Y ($\varepsilon_Y$) et Z ($\varepsilon_Z$). L'homme de l'art saura étendre ce modèle au cas d'un biais ou de non linéarités.

De plus, la relation suivante existe par ailleurs :

$$C^j(X) = \sum_k S_k^j B^k(X) \qquad (2)$$

où S représente la transposée de la matrice d'attitude Q de la carte capteurs sur laquelle sont montés les magnétomètres 3.

Ainsi, dans le cas où le champ magnétique est généré par un générateur 2 à bobines de Helmholtz à six bobinages 21, comme cela est le cas dans la variante illustrée sur la figure 1, il est obtenu :

$$B^k(X) = \sum_m T_m^k(X, \mu) I^m \qquad (3)$$

où $T_m^k(X, \mu)$ représente le modèle paramétrique du champ magnétique, ici en l'occurrence sous la forme d'une matrice de transfert, entre le champ magnétique généré par le générateur 2 et les courants dans les six bobinages 21. Et où $I^m$

correspond au courant électrique dans la bobine m. Le modèle paramétrique du champ magnétique $T_m^k(X, \mu)$ dépend d'un ensemble de paramètres qui sont rassemblés dans le vecteur $\mu$. Le vecteur $\mu$ comprend les paramètres de calibration du champ magnétique obtenus lors de l'étape E6.

De plus, la relation suivante peut être établie :

$$X[a, p]^i = O[p]^i + \sum_j Q[p]_j^i P[a]^j \qquad (4)$$

Où $O[p]^i$ est la i-ème coordonnée dans le repère du générateur 2 de l'origine du repère capteurs lors de son p-ième positionnement dans le générateur 2. Le repère capteurs est un repère permettant de déterminer l'emplacement des magnétomètres 3 de manière relative en utilisant un des magnétomètres 3 comme référence, formant ainsi l'origine du repère capteurs. Où $Q[p]$ est la matrice d'attitude des magnétomètres 3, la matrice d'attitude donnant l'orientation des magnétomètres 3. Où $P[a]^j$ est la j-ème coordonnée dans le repère capteurs du magnétomètre $a$. Et où $X[a,p]$ est la position du magnétomètre $a$ lors de son $p$-ième positionnement dans le générateur 2.

Ainsi, on obtient le modèle de mesure paramétrique suivant pour les magnétomètres 3 :

$$Y^i(X[i, p]) = \sum_j \sum_k \sum_m d_j^i S[p]_k^j T_m^k \left( O[p]^n + \sum_o Q[p]_o^n P[i]^o, \mu \right) I^m \qquad (5)$$

Où $Y^i(X[i,p])$ représente la mesure scalaire du magnétomètre $i$ lors de son $p$-ième positionnement dans le générateur 2.

La matrice de transfert mesurée lors du pième positionnement des magnétomètres 3 dans le générateur 2 est définie de la manière suivante :

$$H[p] = \left( H_m^i(X[i, p]) \right)_{1 \leq i \leq \text{nb magnétomètres}, 1 \leq m \leq 6} \qquad (6)$$

Où i correspond ici au nombre de magnétomètres 3 sur la carte capteurs à calibrer, où $p$ correspond au nombre de positionnement de la carte capteurs comprenant les magnétomètres 3 dans le générateur 2, et où $m$ correspond au nombre de bobinages 21 du générateur 2.

On obtient donc l'équation suivante :

$$H_m^i(X[i, p]) = \sum_j \sum_k d_j^i S[p]_k^j T_m^k \left( O[p]^n + \sum_o Q[p]_o^n P[i]^o, \mu \right) \qquad (7)$$

La matrice $H_m^i(X[i, p])$ est la matrice de transfert qui est déterminée lors de l'étape E4, et plus précisément lors de la p-ième mise en œuvre de l'étape E4 par le procédé.

Nous allons détailler ici comment les modèles de transferts mesurés peuvent être calculés.

En disposant d'une série de $N$ échantillons de mesures simultanées du champ magnétique par n magnétomètres : $(y_i(t_j))_{1 \leq i \leq n, 1 \leq j \leq N}$.

Ces mesures dépendant linéairement à chaque instant de $p$ variables qui représentent les mesures des courants électriques dans les bobinages du générateur : $(x_k(t_j))_{1 \leq k \leq p, 1 \leq j \leq N}$.

On obtient donc pour tout $i,j$:

$$y_i(t_j) = f_i \left( x_1(t_j), x_2(t_j), \dots, x_p(t_j) \right) \qquad (8)$$

Pour les cas linéaires :

Les fonctions, ou transferts $f_i$ sont des fonctions linéaires de $(x_1(t_j), x_2(t_j), \dots, x_p(t_j))$.

C'est à dire qu'il est possible d'écrire $y_i(t_j)$ combinaisons linéaires des $(x_1(t_j), x_2(t_j), \dots, x_p(t_j))$:

$$y_i(t_j) = T_{i,1}x_1(t_j) + T_{i,2}x_2(t_j) + \dots + T_{i,p}x_p(t_j) \quad (9)$$

La matrice $T = (T_{i,k})_{1\leq i\leq n, 1\leq k\leq p}$ est la matrice de transfert reliant les mesures $y$ aux variables $x$

Pour calculer $T$, il suffit de connaitre les valeurs $y_i(t_j)$ lorsque les $p$ séquences temporelles $x_k(t_j)$ sont linéairement indépendantes (aucune séquence temporelle $x_k(t_j)$ ne s'obtient par combinaison linéaire des $p - 1$ autres).

Exemple avec pour $p = 2$ :

$$\left(x_1(t_1), x_1(t_2)\right) = (1,0)$$
$$\left(x_2(t_1), x_2(t_2)\right) = (0,1) \quad (10)$$

On obtient alors :

$$\left(y_i(t_1), y_i(t_2)\right) = \left(T_{i,1}x_1(t_1) + T_{i,2}x_2(t_1), T_{i,1}x_1(t_2) + T_{i,2}x_2(t_2)\right) = \left(T_{i,1}, T_{i,2}\right) \quad (11)$$

Par conséquent, on déduit immédiatement des valeurs de $(y_i(t_1), y_i(t_2))$ et $(x_1(t_1), x_1(t_2))$ les valeurs des coefficients $T_{i,1}$, $T_{i,2}$.

Autrement dit, en supposant que la quantité mesurée $y$ (mesure de champ magnétique) dépend linéairement de $x$ (mesure de courant), il suffit d'exciter le système en modifiant $x$ (le courant) pour identifier la relation entre $y$ et $x$, par exemple par régression linéaire. La condition pour que l'identification soit possible, notamment par régression linéaire, est l'indépendance linéaire entre les différents $x_k$ au cours de tout l'enregistrement (les courants sont linéairement indépendants).

Pour le cas affine (cas particulier pour le linéaire) :

$$y_i(t_j) = T_{i,1}x_1(t_j) + T_{i,2}x_2(t_j) + \dots + T_{i,p}x_p(t_j) + b_i \quad (12)$$

est équivalent au cas linéaire, puisqu'il suffit de définir $x_{p+1}(t_j) = 1$ :

$$y_i(t_j) = T_{i,1}x_1(t_j) + T_{i,2}x_2(t_j) + \dots + T_{i,p}x_p(t_j) + b_i x_{p+1}(t_j) \quad (13)$$

Le coefficient $b_i$ se calcule alors comme un nouveau coefficient d'une matrice de transfert.

Les régressions linéaires ou affines se nomment aussi interpolation linéaire ou affine.

Pour les cas non-linéaires :

Les fonctions, ou transferts $f_i$ sont des fonctions non-linéaires de :

$$\left(x_1(t_j), x_2(t_j), \dots, x_p(t_j)\right) \quad (14)$$

Il est possible, par exemple, de faire l'hypothèse que ces fonctions sont des polynômes à plusieurs variables. Identifier les fonctions $f_i$ sous cette forme revient donc à effectuer une interpolation polynomiale.

Par exemple, pour une interpolation d'ordre 2, pour tout i et j on a:

$$y_i(t_j) = \sum_{1\leq k\leq p} T_{i,k}x_k(t_j) + \sum_{1\leq k_1\leq k_2\leq p} T_{i,k_1,k_2}\, x_{k_1}(t_j)x_{k_2}(t_j) \quad (15)$$

Les coefficients $T_{i,k}$ et $T_{i,k_1,k_2}$ se déduisent de la connaissance des $y_i(t_j)$ et $x_k(t_j)$ par régression polynomiale à partir de l'équation ci-dessus, sous réserve de choisir les $x_k(t_j)$ de sorte que le système soit bien conditionné.

Pour les bobines de Helmholtz, la mesure magnétique $y_i(t_j)$ est fonction (linéaire ou non) du champ magnétique à la position effective du magnétomètre $i$ au pas d'échantillonnage $t_j$ par un modèle de mesure.

Tant que le magnétomètre est maintenu immobile, ce champ magnétique ne dépend que des courants que l'on notera $I_k(t_j)$, laquelle dépendance est linéaire en raison des lois de la physique.

Par conséquent, en excitant le système en faisant varier convenablement les $I_k$ en fonction du temps, on est capable d'interpoler (linéairement ou non) la fonction reliant la mesure aux courants, correspondant au modèle de transfert à partir des mesures.

Par ailleurs, si la position et l'orientation du magnétomètre est connue, que les bobinages sont calibrés et que le capteur est calibré, il est possible de prédire le modèle de transfert que l'on doit obtenir. Il est alors possible, par une méthode d'optimisation, de déduire le modèle de mesure, le modèle de calibration des bobinages, et la position et l'orientation du magnétomètre pendant la phase d'immobilité ayant permis de calculer le modèle de transfert.

En comparant les modèles de transfert mesurés et le modèle de transfert paramétrique, il est possible de trouver une unique solution pour les paramètres de calibration des magnétomètres 3 (qui sont ici : $d_j^i$, $P[i]°$) ainsi que pour le vecteur $\mu$ comprenant les paramètres de calibration du champ magnétique du générateur 2.

Ces paramètres peuvent être déterminés par exemple en utilisant un algorithme de descente de gradient afin de résoudre, pour lesdits paramètres à déterminer, le système d'équation associé à l'ensemble des transferts mesurés. Ceci revient à minimiser la somme quadratique des écarts entre la matrice de transfert paramétrique et les matrices de transfert mesurées.

Les paramètres $Q[p]_o^n$ et $O[i]°$, respectivement la matrice d'attitude correspondant respectivement à l'orientation et l'emplacement des magnétomètres dans le générateur sont également identifiés. Ce sont des sousproduits de l'identification qui ne participent pas à la calibration du système magnétique, mais qui sont nécessaires pour bien poser le problème d'optimisation.

Un des avantages du procédé proposé est de ne pas nécessiter une calibration ou étalonnage préalable du dispositif de calibration, et donc du générateur 2. En effet, le procédé permet, simultanément au calcul des paramètres de calibration du magnétomètre 3, l'ajustement d'un modèle paramétrique du champ magnétique dans la zone ou le dispositif à calibrer est positionné.

Par ailleurs, si le modèle paramétrique du champ magnétique utilisé est suffisamment fin, les inhomogénéités du champ magnétique peuvent être détectées durant le procédé de calibration des magnétomètres. Ainsi, il est possible d'utiliser un dispositif à bobines de Helmholtz sans se restreindre à uniquement utiliser la zone centrale du dispositif dans laquelle le champ magnétique généré est homogène.

Comme modèle paramétrique du champ magnétique, les modèles suivants peuvent par exemple être utilisés :

- un modèle de champ affine (ordre 1), comme par exemple :

$$B(X,\mu) = B_0 + \nabla B_0 (X - X_0) \qquad (16)$$

Où $\nabla B_0$ est un gradient symétrique à trace nulle. Les paramètres de modèle à identifier sont alors $\mu = (B_0, \nabla B_0)$, soit les trois composantes de B et les cinq composantes indépendantes de $\nabla B_0$.

- un modèle de champ d'ordre 2, comme par exemple :

$$B(X,\mu) = B_0 + \nabla B_0 (X - X_0) + \begin{pmatrix} (X - X_0)^T H_x (X - X_0) \\ (X - X_0)^T H_y (X - X_0) \\ (X - X_0)^T H_z (X - X_0) \end{pmatrix} \qquad (17)$$

Où $\nabla B_0$ est un gradient symétrique à trace nulle et où Hx, Hy et Hz sont des Hessiennes symétriques à trace nulle. Les paramètres de modèle à identifier sont alors $\mu = (B_0, \nabla B_0, H_x, H_y, H_z)$, soit les trois composantes de B, les cinq composantes indépendantes de $\nabla B_0$, et les composantes de la Hessienne $(H_x, H_y, H_z)$.

- un modèle de type à éléments finis.

Il pourra être pris $T_m^k(X,\mu) = B(X,\mu)/I_0$ selon l'un ou l'autre des modèles, avec $I_0$ une constante muette dans le problème permettant d'assurer que les variables ont les bonnes unités.

Par ailleurs, le biais des magnétomètres 3 est également un paramètre de calibration pouvant être mesuré par le procédé de calibration décrit précédemment. Selon une autre variante possible, le biais des magnétomètres 3 est mesuré en mesurant le champ magnétique mesuré par lesdits magnétomètres 3 lorsque lesdits magnétomètres 3 sont disposés dans un dispositif (également appelé boîte 0 Gauss) à l'intérieur duquel le champ magnétique est nul.

Par ailleurs, il est possible de ne déterminer que certains paramètres de calibration du ou des magnétomètres 3 et/ou des paramètres de calibration du champ magnétique lorsque seuls ces paramètres de calibration sont considérés comme suffisants pour l'application souhaitée. Il est ainsi possible de supposer des paramètres de calibration dont on ne souhaite pas calculer la valeur comme connus.

Suivant le type de magnétomètre 3 utilisé, le ou les magnétomètres 3 peuvent être maintenus immobiles à l'intérieur du générateur 2 durant les étapes de mesure entre chaque changement de position. Il peut cependant ne pas être nécessaire de maintenir le ou les magnétomètres 3 immobiles en utilisant des courants électriques avec une fréquence suffisamment haute, typiquement des fréquences supérieures à 1kHz, et par exemple de de 10kHz.

Pour des magnétomètres 3 possédant un modèle de mesure non linéaire, il est possible de déterminer les paramètres de calibration en adaptant le profil de courant, c'est-à-dire en adaptant l'intensité et la fréquence du courant dans chacun des bobinages 21 du générateur 2.

Par ailleurs, ci-dessous est détaillé un algorithme d'optimisation pour un cas n'utilisant pas de modèles de transfert mesurés (pas d'étape E40).

Pour chaque ensemble p de courant et de position, on peut combiner les équations (5) et (16) pour donner un exemple dans un cas plus général qui donne, pour chaque magnétomètre $i$:

$$Y^i(param, I^m[p], O[p], Q[p])$$

$$= \sum_j \sum_k \sum_m d_j^i S[p]_k^j \left( B_0 + \nabla B_0 \left( O[p]^n + \sum_o Q[p]_o^n P[i]^o - X_0 \right) \right) I^m \quad (18)$$

avec *param* = $(\{P[i]\}_i, \{d^i\}_i, B_0, \nabla B_0)$

Le problème d'optimisation peut donc s'écrire en fonction des mesures $Y_{mesuré}^i[p]$ du champ magnétique par les magnétomètres 3 et des mesures $I_{mesuré}^m[p]$ des courants électriques dans les bobinages 21 sous les formes suivantes

forme 1 :

$$\underset{param, \{O[p]\}_p, \{Q[p]\}_p}{\mathrm{argmin}} \sum_p \sum_i \left\| Y_{mesuré}^i[p] - Y^i(param, I_{mesuré}^m[p], O[p], Q[p]) \right\|^2 \quad (19)$$

où $\| \ \|$ est une norme (L1, L2 ou autre)

forme 2 :

$$\underset{\substack{param, \{O[p]\}_p, \{Q[p]\}_p, \{I\_[p]\}_p, \{Y\_[p]\}_p \\ sc.Y\_[p]-Y^i(param, I\_[p], O[p], Q[p])}}{\mathrm{argmin}} \sum_p \sum_i \alpha \left\| Y_{mesuré}^i[p] - Y\_[p] \right\|^2$$

$$+ \beta \left\| I_{mesuré}^m[p] - I\_[p] \right\|^2 \quad (20)$$

où $\alpha$ et $\beta$ sont des paramètres dimensionnels.

*Produit programme d'ordinateur*

Selon un troisième et un quatrième aspects, l'invention concerne un produit programme d'ordinateur comprenant des instructions de code pour l'exécution (sur les moyens de traitement 40) d'un procédé de calibration d'au moins un magnétomètre 3 selon l'une quelconque des variantes possibles de l'invention, ainsi que des moyens de stockage lisibles par un équipement informatique (par exemple la mémoire 42) sur lequel on trouve ce produit programme d'ordinateur.

*Calibration du générateur*

Selon un autre aspect, l'invention permet d'étalonner le générateur 2, notamment en mesurant la forme et la taille de la zone dans laquelle le champ magnétique généré par le générateur 2 est homogène.

Le modèle paramétrique du champ magnétique donne en effet théoriquement la taille et la forme de la zone sur laquelle ledit champ magnétique est homogène.

L'invention permet d'améliorer ce modèle paramétrique en utilisant les paramètres de calibration du champ magnétique mesurés en même temps que les paramètres de calibration des magnétomètres 3. Avec ce modèle paramétrique amélioré, il est possible de déterminer la taille et la forme réelles de la zone sur laquelle ledit champ magnétique est homogène.

Or, la forme et la taille de la zone dans laquelle le champ magnétique est homogène dépend de paramètres mécaniques du générateur 2, comme par exemple la forme des bobinages 21, l'orientation relatives desdits bobinages 21, ainsi que de paramètres liés à l'électronique du générateur 2, comme par exemple la stabilité des alimentations électriques.

Ainsi, grâce à l'invention, il est donc possible de déterminer les paramètres mécaniques et électroniques du générateur 2 responsables des défauts que présente le champ magnétique généré, permettant ainsi d'étalonner le générateur 2.

**Revendications**

1. Procédé de calibration d'au moins un magnétomètre (3), le procédé étant **caractérisé en ce qu'**il comprend les étapes suivantes :

   E1 : placer au moins un magnétomètre (3) à l'intérieur d'un générateur (2) d'un champ magnétique, ledit générateur (2) comprenant une pluralité de bobinages (21) ;
   E2 : générer un champ magnétique dans le générateur (2) en appliquant des courants électriques aux différents bobinages (21) ;
   E3 : mesurer le champ magnétique généré dans le générateur (2) avec ledit au moins un magnétomètre (3), et mesurer les courants électriques appliqués aux bobinages du générateur (2) ;
   E4 : répéter l'étape E3 en modifiant à chaque fois une position dudit au moins un magnétomètre (3) à l'intérieur du générateur (2) et/ou les courants électriques dans les bobinages (21) du générateur (2) de sorte à obtenir des mesures du champ magnétique et des courants électriques appliqués aux bobinages pour une pluralité de positions dudit au moins un magnétomètre (3) et/ou de courants électriques dans les bobinages (21) ;
   E40 : calculer un modèle de transfert mesuré entre la mesure du champ magnétique par le au moins un magnétomètre et les courants électriques appliqués aux bobinages (21) pour les différentes positions dudit au moins un magnétomètre (3) et/ou les différents courants électriques dans les bobinages (21), à partir d'une part des mesures dudit champ magnétique et d'autre part des mesures desdits courants électrique appliqués aux bobinages (21) ;
   E5 : générer un modèle de transfert paramétrique à partir d'un modèle de mesure paramétrique dudit au moins un magnétomètre (3) et d'un modèle paramétrique du champ magnétique, le modèle de mesure paramétrique dudit au moins un magnétomètre (3) comprenant des paramètres de calibration dudit au moins un magnétomètre (3) ;
   E6 : calculer les paramètres de calibration du au moins un magnétomètre (3) avec un algorithme d'optimisation à partir du modèle de transfert paramétrique généré à l'étape E5, des modèles de transfert mesuré calculés à l'étape E40, et des mesures du champ magnétique et des courants électriques réalisées dans les étapes E3 et E4.

2. Procédé selon la revendication 1, dans lequel le procédé comprend en outre une étape de contrôle la température dudit au moins un magnétomètre (3) à calibrer.

3. Procédé selon la revendication 1 ou la revendication , dans lequel le au moins un magnétomètre (3) possède une réponse linéaire, le modèle de transfert mesuré étant une matrice de transfert mesurée qui est calculée par régression linéaire, le modèle de transfert paramétrique étant une matrice de transfert paramétrique.

4. Procédé selon la revendication 1 ou la revendication 2, dans lequel le au moins un magnétomètre (3) possède une répondre non-linéaire, le modèle de transfert mesuré étant calculé avec un modèle polynomial ou un modèle en séries de Fourier.

**5.** Procédé selon l'une quelconque des revendications précédentes, dans lequel le générateur (2) est un dispositif à bobines de Helmholtz triaxes comprenant six bobinages (21).

**6.** Procédé selon l'une quelconque des revendications précédentes, dans lequel le procédé comprend une étape d'identification d'un biais dudit au moins un magnétomètre (3), l'étape d'identification étant réalisée en plaçant ledit au moins un magnétomètre (3) dans un dispositif isolant ledit au moins un magnétomètre (3) de tout champ magnétique.

**7.** Procédé selon l'une quelconque des revendications précédentes, dans lequel le procédé est appliqué sur une pluralité de magnétomètres (3), les paramètres de calibration des magnétomètres (3) comprenant un emplacement des magnétomètres (3) défini par rapport à un des magnétomètres (3) servant de référence.

**8.** Procédé selon l'une quelconque des revendications précédentes, dans lequel ledit au moins un magnétomètre (3) est maintenu fixe durant l'étape E2 de génération du champ magnétique à l'intérieur du générateur (2) et durant l'étape E3 de mesure du champ magnétique et du courant électrique appliqué à chacun des bobinages (21).

**9.** Procédé selon l'une quelconque des revendications précédentes, dans lequel les paramètres de calibration du au moins un magnétomètre comprennent : une position dudit au moins un magnétomètre (3) sur un support sur lequel ledit au moins un magnétomètre est monté, un facteur directionnel de mesure dudit au moins un magnétomètre (3), et/ou un biais dudit au moins un magnétomètre (3).

**10.** Procédé selon l'une quelconque des revendications précédentes, dans lequel le modèle paramétrique du champ magnétique est un modèle de champ d'ordre 1, un modèle de champ d'ordre 2, ou un modèle à éléments finis.

**11.** Equipement de calibration d'au moins un magnétomètre (3) comprenant au moins un magnétomètre (3), un générateur (2) d'un champ magnétique qui comprend une pluralité de bobinages (21), **caractérisé en ce qu'**il comprend également un capteur de courant (5) configuré pour mesurer le courant dans chacun des bobinages (21), et des moyens de traitement (4) qui sont configurés pour :

- générer un modèle de transfert paramétrique à partir d'un modèle de mesure paramétrique dudit au moins un magnétomètre (3) et d'un modèle paramétrique du champ magnétique, le modèle de mesure paramétrique dudit au moins un magnétomètre (3) comprenant des paramètres de calibration dudit au moins un magnétomètre (3) ;
- calculer un modèle de transfert mesuré entre la mesure du champ magnétique par le au moins un magnétomètre et les courants électriques appliqués aux bobinages (21) pour les différentes positions dudit au moins un magnétomètre (3) et/ou les différents courants électriques dans les bobinages (21), à partir d'une part des mesures dudit champ magnétique et d'autre part des mesures desdits courants électrique appliqués aux bobinages (21) ;
- calculer les paramètres de calibration du au moins un magnétomètre (3) avec un algorithme d'optimisation à partir du modèle de transfert paramétrique, des modèles de transfert mesuré calculés et de mesures du champ magnétique par ledit au moins un magnétomètre (3) et de mesures des courants dans les bobinages (21).

**12.** Produit programme d'ordinateur comprenant des instructions de code qui conduisent l'équipement de calibration selon la revendication 11 à exécuter les étapes du procédé selon les revendications 1-10.

**13.** Moyen de stockage lisible par un équipement informatique, sur lequel est enregistré le produit programme d'ordinateur selon la revendication 12.

**Patentansprüche**

**1.** Kalibrierungsverfahren wenigstens eines Magnetometers (3), wobei das Verfahren **dadurch gekennzeichnet ist, dass** es die folgenden Schritte umfasst:

E1: Einsetzen wenigstens eines Magnetometers (3) im Innern eines Erzeugers (2) eines Magnetfeldes, wobei der genannte Erzeuger (2) eine Vielzahl von Wicklungen (21) umfasst;
E2: Erzeugen eines Magnetfeldes in dem Erzeuger (2) durch Anwenden von elektrischen Strömen auf die unterschiedlichen Wicklungen (21);

E3: Messen des in dem Erzeuger (2) erzeugten Magnetfeldes mit dem genannten wenigstens einen Magnetometer (3) und Messen der auf die Wicklungen des Erzeugers (2) angewendeten elektrischen Ströme;

E4: Wiederholen des Schritts E3 unter Abändern einer Position des genannten wenigstens einen Magnetometers (3) im Innern des Erzeugers (2) und/oder der elektrischen Ströme in den Wicklungen (21) des Erzeugers (2) jedes Mal derart, dass Messungen des Magnetfeldes und der auf die Wicklungen angewendeten elektrischen Ströme für eine Vielzahl von Positionen des genannten wenigstens einen Magnetometers (3) und/oder elektrischer Ströme in den Wicklungen (21) erhalten werden;

E40: Berechnen eines Übertragungsmodells, das zwischen der Messung des Magnetfeldes durch das wenigstens eine Magnetometer und den auf die Wicklungen (21) angewendeten elektrischen Strömen für die unterschiedlichen Positionen des genannten wenigstens einen Magnetometers (3) und/oder den unterschiedlichen elektrischen Strömen in den Wicklungen (21) angewendet werden, ausgehend einerseits von den Messungen des genannten Magnetfeldes und andererseits den Messungen der genannten, auf die Wicklungen (21) angewendeten elektrischen Strömen;

E5: Erzeugen eines parametrischen Übertragungsmodells ausgehend von einem parametrischen Messmodell des genannten wenigstens einen Magnetometers (3) und eines parametrischen Modells des Magnetfeldes, wobei das parametrische Messmodell des genannten wenigstens einen Magnetometers (3) Kalibrierungsparameter des genannten wenigstens einen Magnetometers (3) umfasst;

E6: Berechnen der Kalibrierungsparameter des wenigstens einen Magnetometers (3) mit einem Optimierungsalgorithmus ausgehend von dem in Schritt E5 erzeugten parametrischen Übertragungsmodell, der in Schritt E40 berechneten, gemessenen Übertragungsmodellen und Messungen des Magnetfeldes und der in den Schritten E3 und E4 realisierten elektrischen Ströme.

2. Verfahren gemäß Anspruch 1, bei dem das Verfahren darüber hinaus einen Kontrollschritt der Temperatur des wenigstens einen zu kalibrierenden Magnetometers (3) umfasst.

3. Verfahren gemäß Anspruch 1 oder Anspruch 2, bei dem das wenigstens eine Magnetometer (3) eine lineare Antwort besitzt, wobei das gemessene Übertragungsmodell eine gemessene Übertragungsmatrix ist, die per linearer Regression berechnet wird, wobei das parametrische Übertragungsmodell eine parametrische Übertragungsmatrix ist.

4. Verfahren gemäß Anspruch 1 oder Anspruch 2, bei dem das wenigstens eine Magnetometer (3) eine nicht lineare Antwort besitzt, wobei das gemessene Übertragungsmodell mit einem polynomischen Modell oder einem Modell in Fourierserien berechnet wird.

5. Verfahren gemäß irgendeinem der voranstehenden Ansprüche, bei dem der Erzeuger (2) eine Vorrichtung mit dreiachsigen Helmholtzwicklungen ist, die sechs Wicklungen (21) umfassen.

6. Verfahren gemäß irgendeinem der voranstehenden Ansprüche, bei dem das Verfahren einen Identifizierungsschritt eines Umweges des genannten wenigstens einen Magnetometers (3) umfasst, wobei der Identifizierungsschritt durch Anordnen des genannten wenigstens einen Magnetometers (3) in einer Vorrichtung realisiert wird, die das genannte wenigstens eine Magnetometer (3) von jedem Magnetfeld isoliert.

7. Verfahren gemäß irgendeinem der voranstehenden Ansprüche, bei dem das Verfahren auf einer Vielzahl von Magnetometern (3) angewendet wird, wobei die Kalibrierungsparameter der Magnetometer (3) einen Standort der Magnetometer (3) umfassen, der in Bezug zu einem der Magnetometer (3) definiert wird, die als Bezugsgröße dienen.

8. Verfahren gemäß irgendeinem der voranstehenden Ansprüche, bei dem das genannte wenigstens eine Magnetometer (3) während des Erzeugungsschritts E2 des Magnetfeldes im Innern des Erzeugers (2) und während des Messschritts E3 des Magnetfeldes und des auf jede der Wicklungen (21) angewendeten elektrischen Stroms fest gehalten wird.

9. Verfahren gemäß irgendeinem der voranstehenden Ansprüche, bei dem die Kalibrierungsparameter des wenigstens einen Magnetometers umfassen: eine Position des genannten wenigstens einen Magnetometers (3) auf einem Träger, auf dem das genannte wenigstens eine Magnetometer montiert ist, einen Messungs-Richtungsfaktor des genannten wenigstens einen Magnetometers (3) und/oder einen Umweg des genannten wenigstens einen Magnetometers (3).

10. Vorrichtung gemäß wenigstens einem der voranstehenden Ansprüche, bei dem das parametrische Modell des Magnetfeldes ein Ordnungsfeld-Modell 1, ein Ordnungsfeld-Modell 2 oder ein Modell mit fertigen Elementen ist.

**11.** Kalibrierungsausrüstung wenigstens eines Magnetometers (3), umfassend wenigstens ein Magnetometer (3), einen Erzeuger (2) eines Magnetfeldes, der eine Vielzahl von Wicklungen (21) umfasst, **dadurch gekennzeichnet, dass** er ebenfalls einen Stromsensor (5), der zum Messen des Stroms in jeder der Wicklungen (21) ausgestaltet ist, und Verarbeitungsmittel (4) umfasst, die ausgestaltet sind zum:

- Erzeugen eines parametrischen Übertragungsmodells ausgehend von einem parametrischen Messmodell des genannten wenigstens einen Magnetometers (3) und von einem parametrischen Modell des Magnetfeldes, wobei das parametrische Messmodell des genannten wenigstens einen Magnetometers (3) Kalibrierungsparameter des genannten wenigstens einen Magnetometers (3) umfasst;
- Berechnen eines gemessenen Übertragungsmodells zwischen der Messung des Magnetfeldes durch das wenigstens eine Magnetometer und die auf die Wicklungen (21) angewendeten elektrischen Ströme für die unterschiedlichen Positionen des genannten wenigstens einen Magnetometers (3) und/oder der unterschiedlichen elektrischen Ströme in den Wicklungen (21) ausgehend einerseits von den Messungen des genannten Magnetfelds und andererseits den Messungen der genannten, auf die Wicklungen (21) angewendeten elektrischen Ströme;
- Berechnen der Kalibrierungsparameter des wenigstens einen Magnetometers (3) mit einem Optimierungsalgorithmus ausgehend von dem parametrischen Übertragungsmodell, der berechneten, gemessenen Übertragungsmodelle und von Messungen des Magnetfeldes durch das genannte Magnetometer (3) und von Messungen der Ströme in den Wicklungen (21).

**12.** Computerprogramm-Produkt, umfassend Codeanweisungen, die die Kalibrierungsausrüstung gemäß Anspruch 11 zum Ausführen der Schritte des Verfahrens gemäß den Ansprüchen 1-10 veranlassen.

**13.** Durch eine Informatikausrüstung lesbares Speichermittel, in dem das Computerprogramm-Produkt gemäß Anspruch 12 gespeichert ist.

**Claims**

**1.** A method for calibrating at least one magnetometer (3), the method being **characterised in that** it comprises the following steps of:

E1: placing at least one magnetometer (3) inside a generator (2) of a magnetic field, said generator (2) comprising a plurality of windings (21);
E2: generating a magnetic field in the generator (2) by applying electric currents to the different windings (21);
E3: measuring the magnetic field generated in the generator (2) with said at least one magnetometer (3), and measuring the electric currents applied to the windings of the generator (2);
E4: repeating step E3 by changing each time a position of said at least one magnetometer (3) inside the generator (2) and/or the electric currents in the windings (21) of the generator (2) so as to obtain measurements of the magnetic field and the electric currents applied to the windings for a plurality of positions of said at least one magnetometer (3) and/or of electric currents in the windings (21);
E40: calculating a transfer model measured between the measurement of the magnetic field by the at least one magnetometer and the electric currents applied to the windings (21) for the different positions of said at least one magnetometer (3) and/or different electric currents in the windings (21), from measurements of said magnetic field, on the one hand, and measurements of said electric currents applied to the windings (21), on the other hand;
E5: generating a parametric transfer model from a parametric measurement model of said at least one magnetometer (3) and a parametric model of the magnetic field, the parametric measurement model of said at least one magnetometer (3) comprising parameters for calibrating said at least one magnetometer (3);
E6: calculating the parameters for calibrating the at least one magnetometer (3) with an optimisation algorithm from the parametric transfer model generated in step E5, measured transfer models calculated in step E40, and the measurements of the magnetic field and electric currents performed in steps E3 and E4.

**2.** The method according to claim 1, wherein the method further comprises a step of controlling the temperature of said at least one magnetometer (3) to be calibrated.

**3.** The method according to claim 1 or claim 2, wherein the at least one magnetometer (3) has a linear response, the measured transfer models being a measured transfer matrix which is calculated by linear regression, the parametric transfer model being a parametric transfer matrix.

4. The method according to claim 1 or claim 2, wherein the at least one magnetometer (3) has a nonlinear response, the measured transfer model being calculated with a polynomial model or a Fourier series model.

5. The method according to any of the preceding claims, wherein the generator (2) is a device with three-axes Helmholtz coils comprising six windings (21).

6. The method according to any of the preceding claims, wherein the method comprises a step of identifying a bias of said at least one magnetometer (3), the identification step being performed by placing said at least one magnetometer (3) into a device insulating said at least one magnetometer (3) from any magnetic field.

7. The method according to any of the preceding claims, wherein the method is applied to a plurality of magnetometers (3), the parameters for calibrating the magnetometers (3) comprising a location of the magnetometers (3) defined relative to one of the magnetometers (3) being used as a reference.

8. The method according to any of the preceding claims, wherein said at least one magnetometer (3) is held fixed during step E2 of generating the magnetic field inside the generator (2) and during step E3 of measuring the magnetic field and the electric current applied to each of the windings (21).

9. The method according to any of the preceding claims, wherein the parameters for calibrating the at least one magnetometer comprise: a position of said at least one magnetometer (3) on a support to which said at least one magnetometer is mounted, a measurement directional factor of said at least one magnetometer (3), and/or a bias of said at least one magnetometer (3).

10. The method according to any of the preceding claims, wherein the parametric model of the magnetic field is a first-order field model, a second-order field model, or a finite element model.

11. An equipment for calibrating at least one magnetometer (3) comprising at least one magnetometer (3), a generator (2) of a magnetic field which comprises a plurality of windings (21), **characterised in that** it also comprises a current sensor (5) configured to measure the current in each of the windings (21), and processing means (4) which are configured to:

   - generate a parametric transfer model from a parametric measurement model of said at least one magnetometer (3) and from a parametric model of the magnetic field, the parametric measurement model of said at least one magnetometer (3) comprising parameters for calibrating said at least one magnetometer (3);
   - calculate a transfer model measured between the measurement of the magnetic field by the at least one magnetometer and the electric currents applied to the windings (21) for the different positions of said at least one magnetometer (3) and/or the different electric currents in the windings (21), from measurements of said magnetic field, on the one hand, and measurements of said electric currents applied to the windings (21), on the other hand;
   - calculate the parameters for calibrating the at least one magnetometer (3) with an optimisation algorithm from the parametric transfer model, measured transfer models calculated and measurements of the magnetic field by said at least one magnetometer (3) and measurements of currents in the windings (21).

12. A computer program product comprising code instructions which cause the calibration apparatus according to claim 11 to execute the steps of the method according to claims 1-10.

13. A computing equipment readable storage means, on which the computer program product according to claim 12 is recorded.

FIG. 1

FIG. 2

FIG. 3

## RÉFÉRENCES CITÉES DANS LA DESCRIPTION

### Documents brevets cités dans la description

- US 2017115364 A1

- US 20170067981 A

### Littérature non-brevet citée dans la description

- Two-Step Calibration Methods for Miniature Inertial and Magnetic Sensor Units. **ZHANG ZHI-QIANG.** IEEE Trans. on Industrial Electronics. IEEE Service Center, 01 Juin 2015, vol. 62, 3714-3723